# EUROPEAN PATENT APPLICATION

(11) **EP 3 985 782 A2**
(43) Date of publication of application: **20.04.2022**
(21) Application number: 21202444.2
(22) Date of filing: 13.10.2021
(51) Int. Cl.: H01M 10/44, H01M 10/48

(54) **BATTERY PACK**

(30) Priority: 13.10.2020 KR 20200132205
(71) Applicant: Samsung SDI Co., Ltd., Yongin-si, Gyeonggi-do 17084 (KR)
(72) Inventor: LEE, Tae Jin, 17084 Yongin-si (KR); KIM, Byeong Jo, 17084 Yongin-si (KR)
(74) Representative: Walaski, Jan Filip

(57) **Abstract**

The present disclosure relates to a battery pack capable of detecting an abnormal state of a battery connector. In an example embodiment, the battery pack comprises: a battery including a plurality of battery cells; a battery connector electrically connected to an electrode terminal of the battery and connected to an external connector; a temperature sensing unit for measuring a temperature of the battery connector; a charging/discharging control unit for controlling charging and discharging of the battery; and a main control unit for determining an abnormal state of the battery connector, wherein, when the temperature of the battery connector is higher than a reference temperature, the main control unit may determine that a contact of the battery connector is poor to then issue a reconnection command.

## Description

### 1. Field

The present disclosure relates to a battery pack.

### 2. Description of the Related Art

A secondary battery can be repeatedly charged and discharged, unlike a primary battery that cannot be recharged. A low-capacity secondary battery in which one battery cell is packaged in the form of a pack is used in small portable electronic devices such as mobile phones, and a high-capacity battery in which several tens of cells are connected in the form of a battery pack is used as a power source for driving motors such as electric bicycles and electric vehicles. In particular, battery packs are being applied to various product groups due to the increase in the market of e-mobility as a personal mobility means.

Since the battery pack mounted in such a personal transportation means is exposed to external shocks, the reliability problem of a connection part where the battery pack and a system are connected is emerging. In addition, due to wear and deterioration of a connector for connecting the battery pack, the battery pack may be insecurely connected to the system and a power supply problem may occur.

The above information is only for enhancement of understanding of the background of the invention and therefore it may contain information that does not constitute prior art.

### SUMMARY

The present disclosure provides a battery pack capable of detecting an abnormal state of a battery connector.

A battery pack according to the present disclosure comprises: a battery including a plurality of battery cells; a battery connector electrically connected to an electrode terminal of the battery and connected to an external connector; a temperature sensing unit for measuring a temperature of the battery connector; a charging/discharging control unit for controlling charging and discharging of the battery; and a main control unit for determining an abnormal state of the battery connector, wherein, when the temperature of the battery connector is higher than a reference temperature, the main control unit determines that a contact of the battery connector is poor to then issue a reconnection command.

When the temperature of the battery connector is higher than the upper limit temperature set to be higher than the reference temperature, the main control unit may issue a command to stop charging and discharging to the charging/discharging control unit.

When the battery connector is not reconnected within a predetermined time after the reconnection command, the main control unit may issue a command to stop charging and discharging to the charging/discharging control unit.

When the battery connector is reconnected within a predetermined time after the reconnection command, the main control unit may receive the temperature of the battery connector again through the temperature sensing unit, may compare the same with a reference temperature, and, when the temperature of the battery connector is higher than the reference temperature, may determine that the battery connector has deteriorated to then issue a replacement command.

The main control unit may measure a contact resistance between the battery connector and an external connector, may compare the measured contact resistance with a reference resistance, and when the contact resistance is higher than the reference resistance, may determine that a contact of the battery connector is poor to then issue a reconnection command.

When the battery connector is reconnected within a predetermined time after the reconnection command, the main control unit measures a contact resistance between the battery connector and the external connector again, may compare the measured contact resistance with the reference resistance, and, when the contact resistance is higher than the reference resistance, may determine that the battery connector has deteriorated to then issue a replacement command.

The reference resistance may be a resistance measured when the battery connector is fully inserted into the external connector.

The battery pack may further comprise a display unit that informs a user of information about reconnection or replacement of the battery connector.

A temperature sensor of the temperature sensing unit may be installed in the battery connector.

The temperature sensor of the temperature sensing unit may be installed in a battery management system and may be connected to the battery connector through a wire.

As described above, the battery pack according to an embodiment of the present disclosure may detect an abnormal state of the battery connector by measuring the temperature and contact resistance of the battery connector and comparing the temperature and contact resistance with reference values.

In addition, the battery pack according to an embodiment of the present disclosure may have improved stability and reliability by informing a user of reconnection or replacement according to an abnormal state of the battery connector.

### BRIEF DESCRIPTION OF DRAWINGS

FIG. 1 is a block diagram illustrating a battery pack according to an embodiment of the present disclosure.

FIGS. 2A and 2B are diagrams illustrating a configuration of a temperature sensing unit.

FIG. 3 is a view showing a temperature table stored in a main control unit.

FIG. 4 is a flowchart illustrating a method in which a battery management system determines an abnormal state according to the temperature of a battery connector.

FIG. 5 is a flowchart illustrating a method in which a battery management system determines an abnormal state according to the contact resistance of a battery connector.

### DETAILED DESCRIPTION

Hereinafter, embodiments of the present disclosure will be described in detail.

The subject matter of the present disclosure, however, may be embodied in many different forms and should not be construed as being limited to the example (or exemplary) embodiments set forth herein. Rather, these example embodiments are provided so that this disclosure will be thorough and complete and will convey the aspects and features of the present disclosure to those skilled in the art.

As used herein, the term "and/or" includes any and all combinations of one or more of the associated listed items. In addition, it will be understood that when an element A is referred to as being "connected to" an element B, the element A can be directly connected to the element B or an intervening element C may be present therebetween such that the element A and the element B are indirectly connected to each other.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

In addition, in the accompanying drawings, sizes or thicknesses of various components are exaggerated for brevity and clarity. Like numbers refer to like elements throughout.

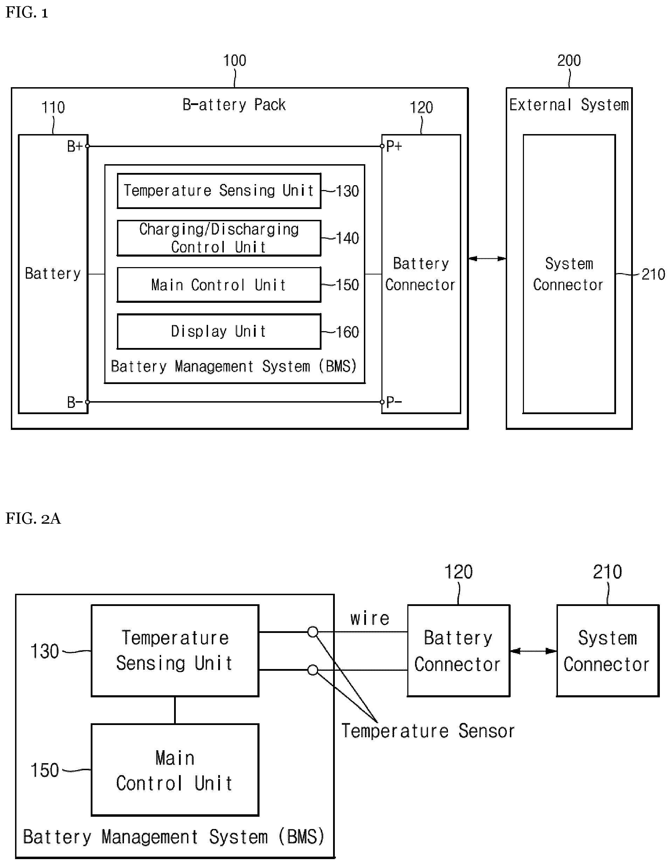

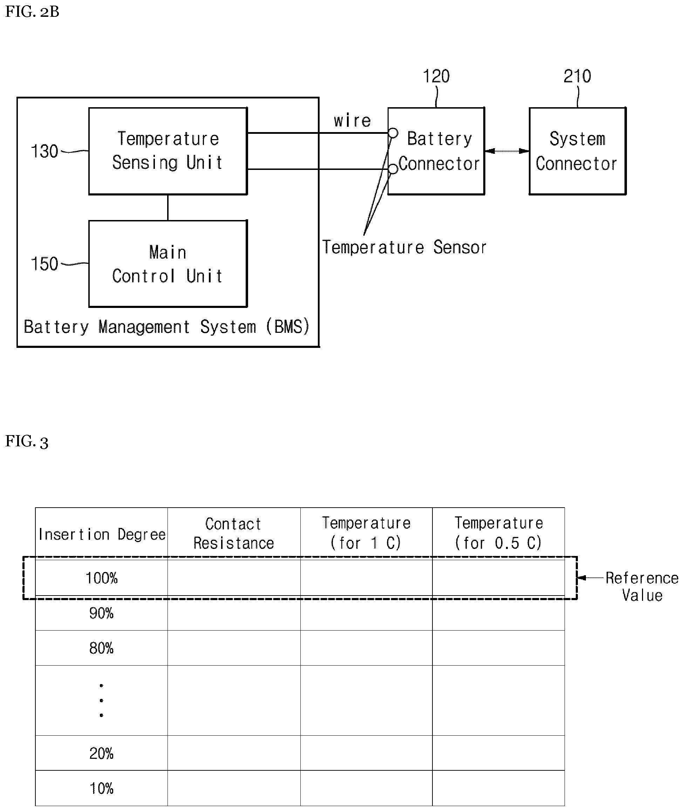

FIG. 1 is a block diagram illustrating a battery pack according to an embodiment of the present disclosure. FIGS. 2A and 2B are diagrams illustrating a configuration of a temperature sensing unit.

Referring to FIG. 1, a battery pack 100 according to an embodiment of the present disclosure may include a battery 110, a battery connector 120, a temperature sensing unit 130, a charging/discharging control unit 140, a main control unit 150, and a display unit 160. In some examples, the temperature sensing unit 130, the charging/discharging control unit 140, the main control unit 150, and the display unit 160 may be referred to as a battery management system (BMS). The battery pack 100 according to an embodiment of the present disclosure may be connected to an external system 200 through the battery connector 120. Here, the external system 200 may be an electrically driven personal mobility means such as an e-mobility vehicle. In some examples, the external system 200 may include an electric bicycle, an upright vehicle, an electric wheelchair, an ultra-small electric vehicle, or an electric two-wheeled vehicle. The battery pack 100 may be mounted on the external system 200 and thus may supply power to drive the external system 200. Here, the battery connector 120 of the battery pack 100 maybe connected to the system connector 210 of the system 200.

The battery 110 may include at least one battery cell, and may be charged or discharged at a constant voltage. In some examples, in the battery 110, a plurality of battery cells may be connected in series and/or in parallel. The electrical connection relationship of these battery cells may be designed differently depending on the capacity required by the external system 200. The battery 110 has a plus terminal (B+) and a minus terminal (B-). In addition, the plus terminal (B+) and the minus terminal (B-) of the battery 110 are electrically connected to a pack plus terminal (P+) and a pack minus terminal (P-) of the battery pack 100, respectively. Here, a charging element and a discharging element may be connected between the battery plus terminal B+ and the pack plus terminal P+.

The battery connector 120 may include a pack plus terminal (P+) and a pack minus terminal (P-). The battery connector 120 may be coupled or fastened to the system connector 210 of the system 200. In some examples, the battery connector 120 and the system connector 210 can be connected in male/female form. The battery connector 120 is a means for coupling the battery pack 100 to the external system 200, and when a connection between the battery connector 120 and the system connector 210 is normally performed, power can be normally supplied to the external system 200. If the connection between the battery connector 120 and the system connector 210 is unstable, contact resistance between the battery connector 120 and the system connector 210 is increased and the temperature rises, the stability and reliability of the battery pack 100 may be deteriorated. In some examples, the battery connector 120 may have poor contact with system connector 210 due to external impact. In some examples, the battery connector 120 may be worn or deteriorated due to frequent external shocks.

The temperature sensing unit 130 may detect the temperature of the battery connector 120. The temperature sensing unit 130 may be electrically connected to the battery connector 120 through a wire. The temperature sensing unit 130 may sense the temperature of the battery connector 120 through a temperature sensor. In some examples, as shown in FIG. 2A, the temperature sensor may be installed on a circuit board constituting a battery management system (BMS). The temperature sensor may measure the temperature of the battery connector 120 through a wire and transmit the measured temperature to the temperature sensing unit 130. In some examples, as shown in FIG. 2B, the temperature sensor may be directly installed on the battery connector 120, and the temperature sensing unit 130 may receive temperature information of the battery connector 120 measured by the temperature sensor through a wire. For example, the temperature sensor may include a thermistor, a thermocouple, or a resistance temperature detector (RTD).

The charging/discharging control unit 140 may control charging and discharging of the battery 110. In some examples, the charging/discharging control unit 140 may control a charging element or a discharging element positioned between the plus terminal B+ and the pack plus terminal P+ of the battery 110 to charge or discharge the battery 110. For example, each of the charging element and the discharging element may include a field effect transistor (FET) and a parasitic diode. The charging/discharging control unit 140 may operate the charging element and the discharging element according to a command issued from the main control unit 150. For example, when an external power source is connected to the battery connector 120, the charging/discharging control unit 140 may charge the battery 110 by turning on the charging element according to a command of the main control unit 150. In addition, when the external system 200 is connected to the battery connector 120, the charging/discharging control unit 140 may supply power to the external system 200 by discharging the battery 110 by turning on the discharging element according to a command of the main control unit 150.

The main control unit 150 may monitor the voltage and current of the battery 110 to issue a command for charging or discharging the battery 110 to the charging/discharging control unit 140. In addition, the main control unit 150 may receive temperature information of the battery connector 120 from the temperature sensing unit 130 and determine an abnormal state of the battery connector 120. The main control unit 150 may analyze the temperature information of the battery connector 120 to determine an abnormal state such as poor contact, deterioration, wear, impact, and the like, of the battery connector 120.

FIG. 3 is a view showing a temperature table stored in a main control unit.

The main control unit 150 may receive temperature information of the battery connector 120 from the temperature sensing unit 130, and may determine an abnormal state of the battery connector 120 by comparing the temperature information with a reference temperature. The main control unit 150 stores contact resistance according to the coupling degree between the battery connector 120 and the system connector 210 and a temperature table according to the input current. For example, as shown in FIG. 3, the main control unit 150 may store the contact resistance between the battery connector 120 and the system connector 210 when the battery connector 120 and the system connector 210 are normally connected, that is, when the battery connector 120 is 100% inserted into the system connector 210, and temperature information when a current of a reference level flows. Here, the current of a reference level may be set to 0.5A or 1A, which may be the current that is typically generated during use. In addition, the main control unit 150 may store, in each step, the contact resistance between the battery connector 120 and the system connector 210 when the battery connector 120 is inserted 90% to 10% into the system connector 210, the temperature when the current of the reference level flows, and information on the amount of change in temperature. For example, in each step, the amount of change in temperature from the reference level is stored. Here, the step in which the battery connector 120 is inserted into the system connector 210 may be set at intervals of 10%, and can be divided into a total of 10 steps when 100% to 10% is inserted.

The temperature/contact resistance may be measured periodically during use of the system. For example, when the temperature of the battery connector 120 received from the temperature sensing unit 130 is higher than the reference temperature, the main control unit 150 may determine that the contact is poor, and a user may be informed through the display unit 160 to reconnect the battery connector 120. Here, the reference temperature means a temperature measured when the battery connector 120 is 100% (i.e. fully) inserted into a system connector. The reference temperature may be room temperature, and the reference data may be determined in advance of use of the system and stored in a memory of the main control unit 150. In addition, the main control unit 150 may measure current flowing through the battery connector 120 and may compare the measured temperature with the reference temperature corresponding to the measured current.

In some examples, when the temperature of the battery connector 120 is higher than the reference temperature although the user has reconnected the battery connector 120, the main control unit may determine that the battery connector is worn or deteriorated and may instruct the user to replace the battery connector 120 through the display unit 160.

In some examples, when the temperature of the battery connector 120 received from the temperature sensing unit 130 is higher than an upper limit temperature, the main control unit 150 may operate in a protection mode to protect the battery management system (BMS). Here, the upper limit temperature is set to a temperature higher than the reference temperature. For example, the reference temperature may be about 25°C. For example, the upper limit temperature may be set to about 85°C. In some examples, in the protection mode, charging or discharging may be stopped to protect the battery pack 100. Therefore, when the temperature of the battery connector 120 is higher than the upper limit temperature, the main control unit 150 may issue a command to stop charging or discharging of the battery 110 to the charging/discharging control unit 140.

In some examples, the main control unit 150 may measure the contact resistance between the battery connector 120 and the system connector 210, and when the measured contact resistance is higher than the reference resistance, may determine that the contact is poor, and may instruct the user to reconnect the battery connector 120 through the display unit 160. Here, the reference resistance means the contact resistance measured when the battery connector 120 is fully inserted into the system connector 210. In some examples, the main control unit 150 may determine that the battery connector 120 is worn or deteriorated when the contact resistance between the battery connector 120 and the system connector 210 is higher than the reference resistance although the user has reconnected the battery connector 120, and may instruct the user to replace the battery connector 120 through the display unit 160. The display unit 160 may inform the user of a state of the battery connector 120. In some examples, the display unit 160 may be a display device capable of visually displaying information. For example, when the display unit 160 receives from the main control unit 150 that the battery connector 120 is in poor contact, the display unit 160 may display a message to the user to reconnect the battery connector 120. In some examples, the display unit 160 may inform the connection state of the battery connector 120 through the number of LED lights. For example, the display unit 160 may indicate the lit number of LEDs to 5 when the connection of the battery connector 120 is normal, and 5 or less when the connection is poor, and may inform the user of the connection state of the battery connector 120. In addition, after the user reconnects the battery connector 120, the display unit 160 may include an input unit capable of notifying the main control unit 150 of information about the reconnection. In other words, after reconnecting the battery connector 120, the user may notify the main control unit 150 of the reconnection by touching or clicking the input unit. Of course, even if the user does not separately input the recombination state through the input unit, the main control unit 150 may detect that the battery connector 120 is reconnected after being disconnected from the system connector 210. Therefore, when the main control unit 150 detects that the user has reconnected the battery connector 120, the main control unit 150 may receive the temperature of the battery connector 120 again through the temperature sensing unit 130. If the user does not reconnect the battery connector 120 within a predetermined time, the main control unit 150 may issue a command to stop charging or discharging of the battery 110 to the charging/discharging control unit 140.

Next, a method for the battery management system to determine the abnormal state of the battery connector will be described.

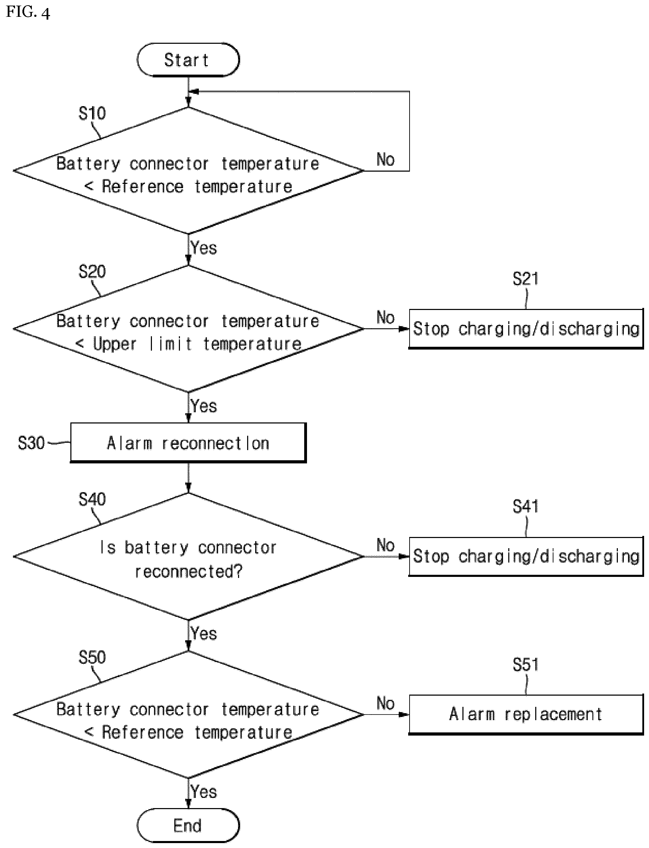

FIG. 4 is a flowchart illustrating a method in which a battery management system determines an abnormal state according to the temperature of a battery connector.

First, the main control unit 150 may receive the temperature of the battery connector 120 measured by the temperature sensing unit 130, and may compare the measured temperature of the battery connector 120 with a reference temperature (S10). When the temperature of the battery connector 120 is higher than the reference temperature, the main control unit 150 may compare the temperature of the battery connector 120 with the upper limit temperature (S20). When the temperature of the battery connector 120 is higher than the upper limit temperature, the main control unit 150 may issue a command to the charging/discharging control unit 140 to stop charging or discharging the battery 110 (S21).

When the temperature of the battery connector 120 is higher than the reference temperature and lower than the upper limit temperature, the main control unit 150 may determine that the contact between the battery connector 120 and the system connector is poor, and may generate a reconnection alarm through the display unit 160 (S30) to indicate that the battery connector 120 should be reconnected, in other words that connection should be made again. For example, if the battery connector is a male connector and the system connector is a female connector, the male connector should be fully pushed into the female connector to make a proper connection. The main control unit 150 determines whether the user has reconnected the battery connector 120 to the system connector 210 within a predetermined time after the reconnection alarm is generated (S40). If it is determined that the user has not reconnected the battery connector 120 within a predetermined time, the main control unit 150 may issue a command to the charging/discharging control unit 140 to stop charging or discharging the battery 110 (S41). Accordingly, the main control unit 150 may protect the battery pack 100 by preventing the battery 110 from being charged or discharged while the battery connector 120 is incompletely coupled.

When it is determined that the user has reconnected the battery connector 120 within a predetermined time, the main control unit 150 may receive the temperature of the battery connector 120 again through the temperature sensing unit 130. The main control unit 150 compares the temperature of the reconnected battery connector 120 with the reference temperature (S50). When the temperature of the battery connector 120 is higher than the reference temperature, the main control unit 150 may determine that a problem has occurred in the component itself such as wear or deterioration of the battery connector 120, and may generate an alarm to replace the battery connector 120 through the display unit 160 (S51). In addition, when the temperature of the battery connector 120 is lower than the reference temperature, the main control unit 150 may determine that the battery connector 120 is normally connected to the system connector 210.

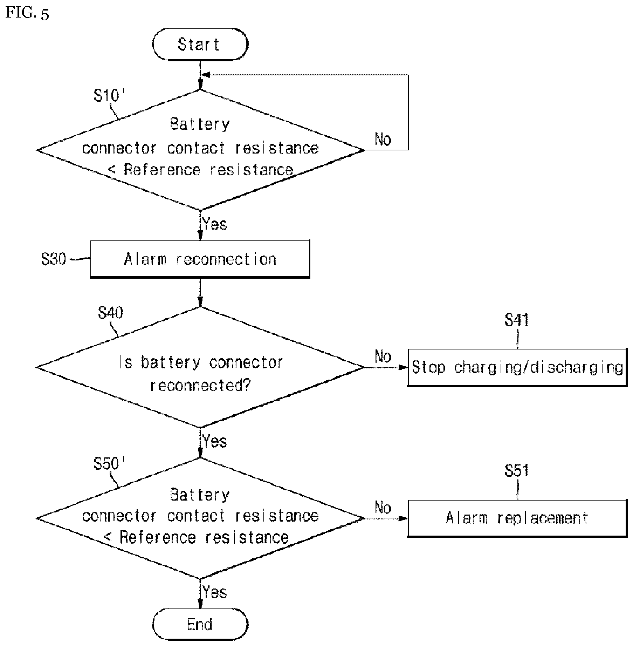

FIG. 5 is a flowchart illustrating a method in which a battery management system determines an abnormal state according to the contact resistance of a battery connector.

First, the main control unit 150 may measure contact resistance between the battery connector 120 and the system connector 210 and may compare the measured contact resistance of the battery connector 120 with a reference resistance (S10'). When the contact resistance between the battery connector 120 and the system connector 210 is higher than the reference resistance, the main control unit 150 may determine that the contact of the battery connector 120 is poor, and may generate a reconnection alarm to reconnect the battery connector 120 through the display unit 160 (S30). The main control unit 150 determines whether the user has reconnected the battery connector 120 within a predetermined time after the reconnection alarm is generated (S40). When it is determined that the user has not reconnected the battery connector 120 within a predetermined time, the main control unit 150 may issue a command to the charging/discharging control unit 140 to stop charging or discharging the battery 110 (S41). Accordingly, the main control unit 150 may protect the battery pack 100 by preventing the battery 110 from being charged or discharged while the battery connector 120 is incompletely connected.

When it is determined that the user has reconnected the battery connector 120 within a predetermined time, the main control unit 150 may measure the contact resistance between the battery connector 120 and the system connector 210 again. The main control unit 150 compares the contact resistance between the reconnected battery connector 120 and the system connector 210 with a reference resistance (S50'). When the contact resistance between the battery connector 120 and the system connector 210 is higher than the reference resistance, the main control unit 150 may determine that a problem has occurred in the component itself, such as wear or deterioration of the battery connector 120, and may generate an alarm to replace the battery connector 120 through the display unit 160 (S51). In addition, when the contact resistance between the battery connector 120 and the system connector 210 is lower than the reference resistance, the main control unit 150 may determine that the battery connector 120 is normally connected to the system connector 210.

It has been described above that the determination as to whether the connection between the battery connector 120 and the external (system) connector 210 has been properly made can be performed by comparing the battery connector temperature to a reference temperature, or by comparing a contact resistance between the connectors to a reference contact resistance, without using the temperature information. However, it is also envisaged that the methods could be used simultaneously or otherwise in combination, for example to confirm a poor connection result provided by one method.

It will further be understood that the detailed disclosure relating to the temperature sensing embodiment also applies to the contact resistance sensing embodiment. For example, the display unit can be used to display alarm conditions for both embodiments.

It will be understood by those of ordinary skill in the art that various changes in form and details may be made to the disclosure without departing from the scope of the present invention as defined by the following claims.

## Claims

1. A battery pack (120) comprising:
a battery (110) including a plurality of battery cells;
a battery connector (120) electrically connected to an electrode terminal of the battery (110) and connectable to a system connector (210) of an external system (200) for supplying battery power to the external system;
a temperature sensing unit (130) for measuring a temperature of the battery connector (120); and
a main control unit (150) for determining the connection state of the battery connector (120), wherein, when the temperature of the battery connector (120) when connected to the system connector (210) is higher than a reference temperature, the main control unit is configured to determine that the connection between the battery connector and the system connector is abnormal, and to provide reconnection information indicating that the battery connector and the system connector should be reconnected.

2. The battery pack of claim 1, further comprising a display unit (160), wherein the reconnection information is configured to be displayed on the display unit.

3. The battery pack of claim 1 or 2, wherein when the temperature of the battery connector (120) when connected to the system connector (210) is higher than an upper limit temperature above the reference temperature, the main control unit is configured to issue a command to stop charging and/or discharging of the battery.

4. The battery pack of any one of the preceding claims, wherein when the battery connector is not reconnected to the system connector within a predetermined time after the reconnection information, the main control unit is configured to issue a command to stop charging and/or discharging of the battery.

5. The battery pack of any one of the preceding claims, wherein when the battery connector is reconnected to the system connector within a predetermined time after the reconnection information, the main control unit is configured to receive the temperature of the battery connector again through the temperature sensing unit, to compare the received temperature with the reference temperature, and, when the temperature of the battery connector is higher than the reference temperature, to determine that the battery connector has deteriorated.

6. The battery pack of claim 5, wherein in response to determining that the battery connector has deteriorated, the main control unit is configured to issue information indicating that the battery connector should be replaced.

7. The battery pack of any one of the preceding claims, further comprising a temperature sensor installed in the battery connector.

8. The battery pack of any one of claims 1 to 6, further comprising a temperature sensor installed in a battery management system of the battery pack and connected to the battery connector through a wire.

9. The battery pack of any one of the preceding claims, wherein the main control unit is configured to measure a contact resistance between the battery connector and the system connector, to compare the measured contact resistance with a reference resistance, and when the contact resistance is higher than the reference resistance, to determine that the connection between the battery connector and the system connector is abnormal, and to provide reconnection information indicating that the battery connector and the system connector should be reconnected.

10. The battery pack of claim 9, wherein when the battery connector is reconnected within a predetermined time after the reconnection information is provided, the main control unit is configured to measure a contact resistance between the battery connector and the system connector again, to compare the measured contact resistance with the reference resistance, and, when the contact resistance is higher than the reference resistance, to determine that the battery connector has deteriorated and to issue information that the battery connector should be replaced.

11. The battery pack of claim 9 or 10, wherein the reference resistance is a resistance measured when the battery connector is fully inserted into the system connector.

12. A battery pack (120) comprising:
a battery (110) including a plurality of battery cells;
a battery connector (120) electrically connected to an electrode terminal of the battery (110) and connectable to a system connector (210) of an external system (200) for supplying battery power to the external system; and
a main control unit (150) for determining the connection state of the battery connector (120), wherein the main control unit is configured to measure a contact resistance between the battery connector and the system connector, and when the contact resistance is higher than the reference resistance, to determine that the connection between the battery connector and the system connector is abnormal, and to provide reconnection information indicating that the battery connector and the system connector should be reconnected.

13. The battery pack of claim 12, wherein when the battery connector is reconnected within a predetermined time after the reconnection information is provided, the main control unit is configured to measure a contact resistance between the battery connector and the system connector again, to compare the measured contact resistance with the reference resistance, and, when the contact resistance is higher than the reference resistance, to determine that the battery connector has deteriorated and to issue information that the battery connector should be replaced.

14. The battery pack of claim 12 or 13, wherein the reference resistance is a resistance measured when the battery connector is fully inserted into the system connector.
